# EUROPEAN PATENT APPLICATION

(11) **EP 4 407 337 A1**
(43) Date of publication of application: **31.07.2024**
(21) Application number: 23153438.9
(22) Date of filing: 26.01.2023
(51) Int. Cl.: G01R 33/565, G01R 33/36, G01N 3/08, G01R 33/48

(54) **SYSTEM AND METHOD FOR MONITORING AND SUPPRESSING RADIO FREQUENCY (RF) NOISE**

(71) Applicant: Koninklijke Philips N.V., 5656 AG Eindhoven (NL)
(72) Inventor: LEUSSLER, Christoph Günther, Eindhoven (NL); HAHN, Artur, Eindhoven (NL); VERNICKEL, Peter, 5656AG Eindhoven (NL); TIECK, Klaus, Eindhoven (NL)
(74) Representative: Philips Intellectual Property & Standards

(57) **Abstract**

In an environment of a medical imaging or therapy system (1) radio frequency (RF) noise should be suppressed and/or avoided. This is achieved by a system for monitoring radio frequency (RF) noise and a computer-implemented method for suppressing and/or avoiding radio frequency (RF) noise. Whereby the medical imaging or therapy system (1) is located inside an operation room (2), the system comprising: a plurality of sensors (4, 5, 7), wherein the sensors (4, 5, 7) are configured for continuous broadband detection of radio frequency (RF) signals, wherein a first sensor (4) is located inside the operation room (2) and a second sensor (5) is located outside the operation room (2), wherein the sensors (4, 5, 7) are configured to provide sensor data, the system further comprising: a processor unit (8), wherein the sensors (4, 5, 7) are connected to the processor unit (8), the processor unit comprising: at least one memory (9) for storing instructions; at least one processor (10) that executes the instructions to cause the following to be performed: calculating a noise level and spectrum based on the sensor data in the processor unit (8); carrying out a procedure for suppressing and/or avoiding RF noise and spurious signals based on the noise level.

## Description

### FIELD OF THE INVENTION

The invention relates to the field of monitoring radio frequency (RF) noise in an environment of a medical imaging or therapy system. The invention further relates to a method for suppressing and/or avoiding radio frequency (RF) noise in an environment of a medical imaging or therapy system.

### BACKGROUND OF THE INVENTION

In the field of medical imaging or therapy systems, positive diagnosis experience is crucial as well as good image quality at the same time. Medical imaging or therapy system will become more and more autonomous with less local operator depended on actions and automated remotely controlled workflow steps. Imaging or therapy guidance requires seamless workflow. For this and other reasons new features will be introduced, wherein the features shall be used within close vicinity to the medical imaging or therapy system. Compatibility e.g., with respect to image quality of the multitude of devices is crucial. External and additional devices such as portable monitoring equipment, sensors for vital signs and mobile anaesthesia systems are controlled by local hospital services and clinical operators. This additional equipment is positioned e.g., in an operating room of a medical imaging or therapy system and connected to AC supply and local communication channels. Positioning and placement are often performed with respect to clinical requirements and constraints such as limited space and accessibility. Signal integrity can so far not be controlled. For example, reports from MRI sites show image quality problems due to spurious signal injection of digital noise in the MRI image band. The spurious signals from digital components such as local switching step up converters are unstable with respect to frequency, amplitude and phase and often correlated to operation modes, positioning, and orientation of the device.

### SUMMARY OF THE INVENTION

It is an object of the invention to provide a system and method for monitoring radio frequency (RF) noise in an environment of a medical imaging or therapy system for suppressing and/or avoiding radio frequency (RF) noise.

According to the invention, this object is addressed by the subject matter of the independent claims. Preferred embodiments of the invention are described in the sub claims.

Therefore, according to the invention, a system for monitoring radio frequency (RF) noise in an environment of a medical imaging or therapy system is foreseen, wherein the medical imaging or therapy system is located inside an operation room, the system comprising: a plurality of sensors, wherein the sensors are configured for continuous broadband detection of radio frequency (RF) signals, wherein a first set of sensors is located inside the operation room and a second set of sensors is located outside the operation room, wherein the sensors are configured to provide sensor data, the system further comprising: a processor unit, wherein the sensors are connected to the processor unit, the processor unit comprising: at least one memory for storing instructions; at least one processor that executes the instructions to cause the following to be performed: calculating a noise level and spectrum based on the sensor data in the processor unit; carrying out a procedure for suppressing and/or avoiding RF noise and spurious signals based on the noise level. In the present application, the operation room is understood to be a room that is shielded by an RF-cage from the outside. This differentiates the terms "inside" and "outside" as being defined by the RF-shielded cabin and the exterior, the unshielded world with all kinds of RF radiation. Continuous broadband sampling contrasts with the known intermittent sampling in the Larmor frequency band. In particular, it can be provided that the continuous broadband sampling of RF signals is at least broader than the MR bandwidth.

In a technically advantageous embodiment of the system at least one processor is arranged to execute a machine learning algorithm. Machine learning can comprise neural networks, autoencoders, decision trees , support vector machines, and other kinds of machine learning. Along with various advantages and possible applications of neural networks and other machine learning techniques, the most common ones are that they help us classify and cluster. Such machine learning models learn (or are trained) by processing examples, each of which contains a known "input" and "result," forming probability-weighted associations between the two, which are stored within the data structure of the model itself. The training from a given example is usually conducted by determining the difference between the processed output of the model (often a prediction) and a target output.
Learning is the adaptation of the machine learning model to better handle a task by considering sample observations. Learning involves adjusting the parameters of the model to improve the accuracy of the result. This is done by minimizing the observed errors. Learning is complete when examining additional observations does not usefully reduce the error rate.

In another technically advantageous embodiment of the system at least one of the sensors is a portable sensor device for on-the-spot RF signal measurements. Portable sensor devices have the advantage that they can be used to take measurements at locations that are of particular importance.

In a technically advantageous embodiment of the system the sensors are coupled to the processor unit via a non-galvanic signal path. In particular, in a technically advantageous embodiment of the system the sensors are connected to the processor unit via an optical and/or shielded wire-based and/or wireless signal path. This has the advantage that a non-galvanic signal path prevents common mode coupling.

In a technically advantageous embodiment of the system the sensors comprising a dual mode antenna for WLAN control and RF signal detection and/or the sensors comprising separate antennas using diplexer for WLAN control and RF signal detection. The antennas can be realized and configured and mixed for sensitivity with respect to electromagnetic E and H field components.

In another technically advantageous embodiment of the system the medical imaging or therapy system is a magnetic resonance imaging (MRI) system, wherein the sensors are time aligned with MRI multi-receiver channels of the MRI system.

In a technically advantageous embodiment of the system the medical imaging or therapy system is a magnetic resonance imaging (MRI) system, wherein at least one sensor for detection of radio frequency (RF) signals is arranged around the MRI system. With the sensors arranged around the MRI system the RF-noise field within the MRI system can be calculated. Before a scan begins, the RF-noise spectrum in the MRI system, coming from sources outside the scanner (e.g., surrounding equipment) can be determined and used as a baseline noise floor estimate. During a scan, the field outside the scanner is monitored by the sensors and the RF-noise inside the scanner can be removed from the acquired k-space signal retrospectively, based on the real-time measurements and the calibration from before the scan.

In another aspect of the invention, a medical imaging or therapy system comprising a system for monitoring of a radio frequency (RF) operation of the magnetic resonance imaging system as described above is foreseen.

In a further aspect of the invention, the object is achieved by a computer-implemented method for suppressing and/or avoiding radio frequency (RF) noise in an environment of a medical imaging or therapy system, by a system for monitoring radio frequency (RF) noise in an environment of a medical imaging or therapy system, wherein the medical imaging or therapy system is located inside an operation room, the system comprising: a plurality of sensors, wherein the sensors are configured for detection of radio frequency (RF) signals, wherein a first sensor is located inside the operation room and a second sensor is located outside the operation room, wherein the sensors are configured to provide sensor data, the system further comprising: a processor unit, wherein the sensors are connected to the processor unit, the processor unit comprising: at least one memory for storing instructions; at least one processor that executes the instructions, the method comprising the following steps: measuring RF signals by the sensors inside the operation room and outside the operation room and providing sensor data; calculating a noise level based on the sensor data in the processor unit; carrying out a procedure for suppressing and/or avoiding RF noise based on the noise level.

The term medical imaging or therapy system can be used to refer to different systems, such as magnetic resonance imaging (MRI) systems, X-Ray systems, computed tomography (CT) systems or therapy systems like linear accelerator-based therapy systems or proton beam therapy systems.

In a technically advantageous embodiment of the method the step of carrying out a procedure based on the noise level is based on a thresholding technique with adaptive window selection. The advantage of this technique is its effectiveness to provide an appropriate procedure.

In another technically advantageous embodiment of the method the step of carrying out a procedure for suppressing and/or avoiding RF noise based on the noise level comprises the step of: changing an operation of components of the medical imaging or therapy system based on the noise level. As long as the noise is correlated with the operating modes, a change in the operation of components of the medical imaging or therapy system can cause an improvement in the noise level.

In a technically advantageous embodiment of the method the step of measuring RF signals by the sensors and providing sensor data comprises the step of: sampling signals from the sensor inside the operation room and from the sensor outside the operation room and the step of a processing the sensor data in the processor unit comprises the step of: subtracting or dividing the sensor data from inside and outside the operating room for calculating a corresponding noise level.

In another technically advantageous embodiment of the method at least one processor is arranged to execute a neural network machine learning algorithm and the step of processing of the sensor data in the processor unit comprises the step of: feeding the sensor data to the neural network machine learning algorithm, wherein the neural network machine learning algorithm is trained to identify devices by the fingerprint of their spurious signal band.

In a technically advantageous embodiment of the method the step of carrying out a procedure based on the noise level comprises the step of: proposing an adapted operation mode for the medical imaging system to an operator to achieve a clinical image with a better image quality.

In another technically advantageous embodiment of the method the medical imaging or therapy system is a magnetic resonance imaging (MRI) system, wherein the sensors inside and outside the operation room are time aligned with an MRI digital multi-receiver of the MRI system and the step of carrying out a procedure based on the noise level comprises the step of: removing noise from clinical image in the k-space or in the image space to the extent possible. In an embodiment of the invention the noise is removed with the help of trained machine learning models. In cases with too strong signal (MRI received signal beyond the dynamic range), machine learning may help estimate the true signal level without the additive RF noise.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a system for monitoring radio frequency (RF) noise in an environment of a medical imaging or therapy system according to an embodiment of the invention,
Fig. 2 depicts a flowchart of a computer-implemented method for suppressing and/ or avoiding radio frequency (RF) noise in an environment of a medical imaging or therapy system according to an embodiment of the invention.

### DETAILED DESCRIPTION OF EMBODIMENTS

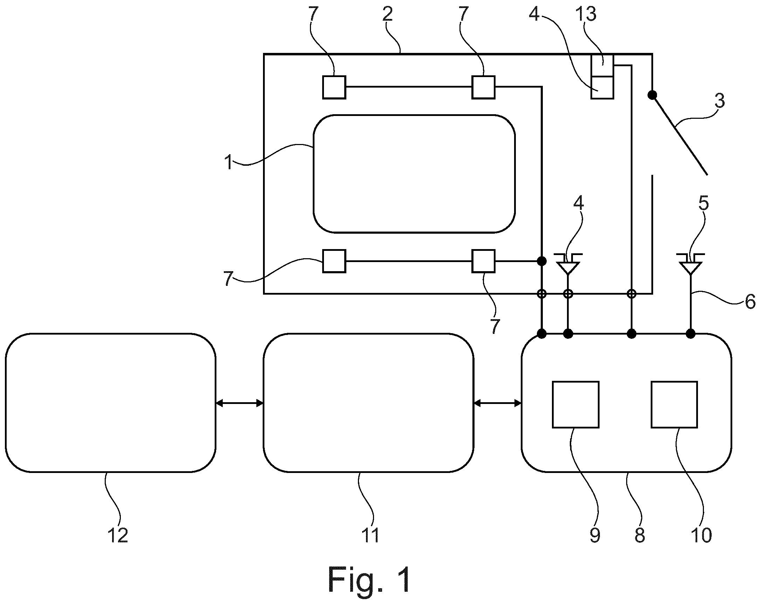

Fig. 1 schematically depicts a system for monitoring radio frequency (RF) noise in an environment of a medical imaging or therapy system 1 according to an embodiment of the invention.

In Fig. 1 a medical imaging or therapy system 1 located inside an operation room 2 is shown, where the room can be entered by means of the door 3 shown in Fig. 1. The medical imaging or therapy system 1 can be, for example a magnetic resonance imaging (MRI) system, an X-Ray system or a computed tomography (CT) system or a therapy system like linear accelerator-based therapy systems or proton beam therapy systems. Another field of application of the invention is the application for interventional radiology suite where biopsy, diagnosis or therapies are precisely guided with real-time fluoroscopy and/or MRI. Here many individual devices are located in the operating room 2 and signal integrity is of high importance for patient safety. The operation room is understood to be a room that is shielded by an RF-cage from the outside. This differentiates the terms "inside" and "outside" as being defined by the RF-shielded cabin and the exterior, unshielded world with all kinds of RF radiation.

The system for monitoring radio frequency (RF) noise comprises a plurality of sensors 4, 5, 7, wherein the sensors 4, 5, 7 are configured for detection of radio frequency (RF) signals. A first sensor 4 is located inside the operation room 2 and a second sensor 5 is located outside the operation room 2, wherein the sensors 4, 5, 7 are configured to provide sensor data. In particular, the sensors can be broadband sensors for measuring RF noise. In particular, the broadband sampling of RF signals is continuously, wherein in an embodiment the sampling is at least broader than the MR bandwidth. Continuous broadband sampling contrasts with the known intermittent sampling in the Larmor frequency band. The sensors 4, 5, 7 are connected to a processor unit 8, wherein the processor unit 8 comprises a memory 9 for storing instructions and a processor 10 that executes the instructions. The sensors can be coupled to the processor unit 8 via a non-galvanic signal path 6, for example. In one embodiment, the use of optical and/or wireless signal path 6 may be provided. In one embodiment continuously broadband sampling, wherein the sampling is at least broader than the MR bandwidth, of the RF signals is foreseen. Sensor data from the sensor 4 located inside the operation room 2 and from the second sensor 5 located outside the operation room 2 can be compared to monitor the integrity of the RF cage. As a consequence, predictive maintenance can be requested.

The processor unit 8 can act as a sensor hub where the signal paths 6 of the sensors converge. For this purpose, the processor unit 8 can also have a Software Defined Radio (SDR), by means of which the sensors 4, 5, 7 can be controlled and configured from remote. The processor 10 can, for example, be a Field Programmable Gate Array (FPGA) on which a logic circuit adapted for the evaluation can be loaded. In particular, it can be provided that the processor 10 is set up to execute a neural network machine learning algorithm. By means of a neural network machine learning algorithm an analysis of the individual noise and signal sources can be done. For this purpose, the neural network was previously trained accordingly. The neural network decides about the information flow e.g., for a remote operator for a predictive maintenance and the system operator. The trained network identifies the devices by the fingerprint of the spurious signal band. Furthermore, the signals of the sensors 4, 5 ,7 can be digitized by means of the processor unit 10. For this purpose, the processor unit 10 comprises corresponding devices such as ADC-converters. The digitized data and preselected information are forwarded, collected and stored in a collection module 11. It is advantageous to have local data processing before submitting data to remote, in order to avoid the huge amounts of data due to continuous broadband sampling. The collection module 11 can join the processor unit 8 as a stand-alone module, but it can also be integrated into the processor unit 8. For example, it may be a cloud-based collection module 11 to save the data outside the system. The collection module 11 can be connected to a service module 12, for example, which is intended for service coordination and failure prediction. Furthermore, the service module 12 can provide further customer guidance features included in an app or it can display guidance data on an output unit such as a monitor.

The sensors 4, 5, 7 are equipped with dual mode antennas or separate antennas using diplexer for WLAN control and separate MR band antenna. The antennas can be realized, configured and mixed in terms of sensitivity to E- and H-field electromagnetic components. Signals from the sensors 4 inside and from the sensors 5 outside the operating room 2 are sampled in an embodiment narrowband in an MRI channel and are subtracted or divided. The Signals are monitored over time, wherein significant changes and signal events are addressed with time stamps, and stored e.g., in the collection module 11. Furthermore, the events are reported for example by means of the output unit of the service module 12. This reduces the amount of data to reasonable amount. Measurements inside the operating room 2 help to localize the issue and classify it in categories like "internal noise source", "broken RF cage" or "broken RF door", "external noise source". A defined threshold alert informs service and operator with respect to image quality. In yet another embodiment, based on the noise level analysis, more rugged MRI sequences are proposed to an operator to achieve a clinical image with accepted image quality.

In addition, it may be provided that the sensors 4, 5, 7 are partially portable sensor devices. Here it can be provided that the portable sensor devices are placed in wall holders 13. For analysis, the portable sensor devices can be taken from the wall holder 13 and be moved though the environment of the medical imaging or therapy system 1 for on-the-spot noise source analysis. To enable this, the portable sensor devices are configured to work battery powered optionally and transmitting the data wirelessly to e.g., the wall holder 13. The wall holder 13 serves as supply/charger and collects data wirelessly and forwards it to the processor unit 8.

When using the system for monitoring radio frequency (RF) noise in an environment of an MRI system, sensors 4 inside and sensors 5 outside the operating room 2 are time aligned with the MRI digital multi-receiver. The signals from the sensors 4, 5, 7 are fed to the processor unit 8 on which a neural network machine learning algorithm runs. The neural network machine learning algorithm is trained to remove noise from clinical image in the k-space or in the image space to exclude possible cases with too strong signal since spurious signal saturates the MR RX chain, leads to non-linearities.

In a further embodiment the signal chain of the sensors 4, 5, 7 can be switched between different modes. Here, for example a mode for narrowband or broadband signal detection can be provided. Also, different modes can be provided for e.g., magnetic resonance imaging. These can be, for example, modes for MR imaging, or a service or installation monitoring mode.

During installation of the medical imaging or therapy system 1 a continuous monitoring of signal integrity by the sensors 4, 5, 7 may be provided. The results e.g., a representation of signal and noise level can be presented on a display unit e.g., a monitor od 3D glasses. Through this guidance and transparency for field service during installation can be provided. This also promotes the awareness of noise generation based by external X-Ray scanners and accessory equipment e.g., anesthesia, monitors, surgical robot and so on, and mitigation by guidance of positioning and orientation. A software subroutine communicates e.g., with the MRI system software and monitors noise analysis for the user and remote operator. At the same time operational stages of the MRI system are added to the data acquired noise sensors 4, 5, 7.

In a further embodiment the sensors 7 can be placed directly around the MRI system, e.g., mounted to the outside bore covers, like a magnetic field camera. The sensors 7 around the MRI system could also transmit in addition to receiving or be paired with sensors around or within the MRI system. This enables active noise cancellation during acquisition by sending a signal through the transmitters that cancels the unwanted RF noise through destructive interference inside the MRI system bore. For real-time processing of the RF noise during scanning, to determine the required transmit fields for active cancellation, fast processing hardware such as FPGAs could be employed, that have the field propagation equations from sensors 4, 5, 7 to receive coils hardware-programmed for efficient processing. Alternatively, to adding dedicated transmitters for active noise cancelling, RF pulses sent by the main transmit coils in the MRI system could be designed such that they know of the RF-noise and send out canceling terms to suppress the RF-noise at the receive coils during acquisition. For example, active sampling technology with automated real-time sequence adjustment may be used. For calculating the noise level based on the sensor data Maxwell equations could be used to calculate the RF-noise field within the MRI system from sensors outside the MRI system.

Sensor data from the first sensors 4 inside the operation room and the sensors 7 placed directly around the MRI system 1 can generally be used to correct the acquired MRI data in postprocessing/reconstruction. This achieves am image denoising/enhancement. Sensor data from the sensors 7 and the MRI receive coils can be compared to rate the fidelity of the acquired MRI data (or the data to be acquired in the planned sequence). If the RF noise dominates the MRI signal, the following measures can be carried out in embodiments of the invention: estimate the effective SNR of the planned image and/or warn the operator and/or suggest more noise-robust MRI sequences (e.g., with more signal averages).

Before a scan begins, the RF-noise spectrum in the MRI system coming from sources outside the MRI system (e.g., surrounding equipment) can be determined and used as a baseline noise floor estimate. During a scan, the field outside the MRI system is monitored by the sensors 4, 5, 7 and the RF-noise inside the MRI system can be removed from the acquired k-space signal retrospectively, based on the real-time measurements and the calibration from before the scan. In an embodiment the additive RF-noise from the acquired k-space data can be removed during postprocessing.

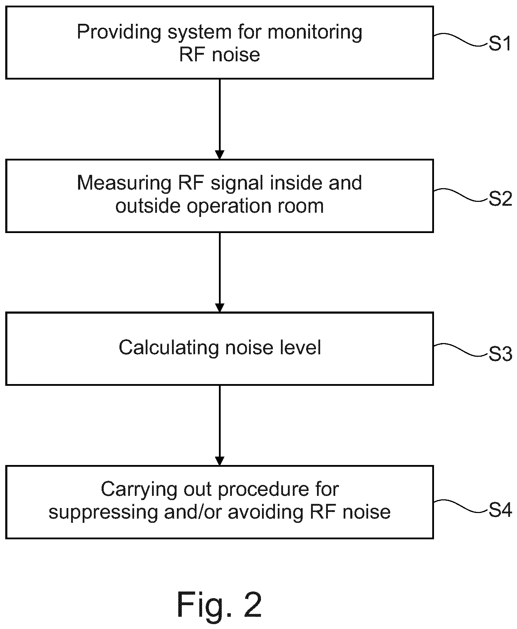

Fig. 2 depicts a flowchart of a computer-implemented method for suppressing and/ or avoiding radio frequency (RF) noise in an environment of a medical imaging or therapy system according to an embodiment of the invention. In step S1 a system for monitoring radio frequency (RF) noise in an environment of a medical imaging or therapy system 1 is provided. The medical imaging or therapy system 1 is located inside an operation room 2. The system comprises a plurality of sensors 4, 5, 7, wherein the sensors 4, 5, 7 are configured for detection of RF signals, wherein a first sensor 4 is located inside the operation room 2 and a second sensor 5 is located outside the operation room 5, wherein the sensors 4, 5, 7 are configured to provide sensor data, the system further comprising: a processor unit 8, wherein the sensors 4, 5, 7 are connected to the processor unit 8. The processor unit 8 comprises at least one memory 9 for storing instructions and at least one processor 10 that executes the instructions. In step S2 RF signals are measured by the sensors 4, 5, 7 inside the operation room 2 and outside the operation room 2 wherein the sensor data is provided. In step S3 a noise level and spectrum based on the sensor data is calculated in the processor unit 8. In an embodiment of the invention the processor 10 is arranged to execute a neural network machine learning algorithm. The step of processing of the sensor data in the processor unit 8 can therefore include the additional step of feeding the sensor data to the neural network machine learning algorithm, wherein the neural network machine learning algorithm is trained to identify devices by the fingerprint of their spurious signal band. In step S4 a procedure for suppressing and/or avoiding RF noise based on the noise level is carried out. For suppressing and/or avoiding RF noise in one embodiment, it may be provided that an operation of components of the medical imaging or therapy system 1 is changed based on the noise level. In a further embodiment an adapted operation mode for the medical imaging system 1 is proposed to an operator to achieve a clinical image with a better image quality. The procedure for suppressing and/or avoiding RF noise therefore involves guiding and alerting an operator of the medical imaging or therapy system 1. This adds an interaction layer with the operator of the medical imaging or therapy system 1 if a noise issue is detected. Only certain MRI sequences might be affected or increasing scan time may keep the scanner up until service arrives.

In an embodiment control and guidance of clinical and interventional workflow based on continuous monitoring of RF noise inside and outside an operating room 2 of a medical imaging or therapy system 1 using real time wideband signal and noise monitoring is foreseen. Furthermore, threshold and window-based action for predictive maintenance and customer guidance are provided. Local processor units 8, comprising e.g., FPGAs analyses using machine learning algorithm to generate and prepare data for guidance of operators and predictive maintenance. Thus, among other things, guidance and monitoring is provided for the operator to optimize the positioning and alignment of the equipment to achieve the highest signal integrity. This improves the workflow for acquiring MR images, for example.

In another embodiment wherein the sensors 4, 5, 7 inside and outside the operation room 2 are time aligned with an MRI digital multi-receiver of the MRI system. Noise from a clinical image in the k-space or in the image space is removed as much as possible using the knowledge about the noise spectrum from the sensor signals from sensors 4 and 7 (within the operation room/RF cabin). This can be achieved, for example, by feeding the signals to a neural network machine learning algorithm running on the processing unit which removes noise from clinical images in the k-space or in the image space.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| medical imaging or therapy system | 1 |
| RF shielded operating room | 2 |
| door | 3 |
| sensor inside operating room | 4 |
| sensor outside operating room | 5 |
| signal path | 6 |
| sensor around medical imaging system | 7 |
| processor unit | 8 |
| memory | 9 |
| processor | 10 |
| collection module | 11 |
| service module | 12 |
| wall holder | 13 |

## Claims

1. A system for monitoring radio frequency (RF) noise in an environment of a medical imaging or therapy system (1), wherein the medical imaging or therapy system (1) is located inside an operation room (2), the system comprising:
- a plurality of sensors (4, 5, 7), wherein the sensors (4, 5, 7) are configured for continuous broadband detection of radio frequency (RF) signals, wherein a first sensor (4) is located inside the operation room (2) and a second sensor (5) is located outside the operation room (2), wherein the sensors (4, 5, 7) are configured to provide sensor data, the system further comprising:
- a processor unit (8), wherein the sensors (4, 5, 7) are connected to the processor unit (8), the processor unit comprising:
- at least one memory (9) for storing instructions,
- at least one processor (10) that executes the instructions to cause the following to be performed:
- calculating a noise level and spectrum based on the sensor data in the processor unit (8),
- carrying out a procedure for suppressing and/or avoiding RF noise and spurious signals based on the noise level.

2. The system according to claim 1, wherein the at least one processor (10) is arranged to execute a machine learning algorithm.

3. The system according to any preceding claim, wherein at least one of the sensors (4, 5, 7) is a portable sensor device for on-the-spot RF signal measurements.

4. The system according to any preceding claim, wherein the sensors (4, 5, 7) are coupled to the processor unit (8) via a non-galvanic signal path (6).

5. The system according to claim 4, wherein the sensors (4, 5, 7) are connected to the processor unit (8) via an optical and/or shielded wire-based and/or wireless signal path (6).

6. The system according to any preceding claim, wherein the sensors (4, 5, 7) comprising a dual mode antenna for WLAN control and RF signal detection and/or the sensors (4, 5, 7) comprising separate antennas using diplexer for WLAN control and RF signal detection.

7. The system according to any preceding claim, wherein the medical imaging or therapy system (1) is a magnetic resonance imaging (MRI) system, wherein the sensors (4, 5, 7) are time aligned with MRI multi-receiver channels of the MRI system.

8. The system according to any preceding claim, wherein the medical imaging or therapy system (1) is a magnetic resonance imaging (MRI) system, wherein at least one sensor (7) for detection of radio frequency (RF) signals is arranged around the MRI system.

9. A medical imaging or therapy system (1) comprising a system for monitoring of a radio frequency (RF) operation of the magnetic resonance imaging system according to any one of claims 1 to 8.

10. A computer-implemented method for suppressing and/or avoiding radio frequency (RF) noise in an environment of a medical imaging or therapy system (1), by a system for monitoring radio frequency (RF) noise in an environment of a medical imaging or therapy system (1), wherein the medical imaging or therapy system (1) is located inside an operation room (2), the system comprising:
- a plurality of sensors (4, 5, 7), wherein the sensors (4, 5, 7) are configured for continuous broadband detection of radio frequency (RF) signals, wherein a first sensor (4) is located inside the operation room (2) and a second sensor (5) is located outside the operation room (5), wherein the sensors (4, 5, 7) are configured to provide sensor data, the system further comprising:
- a processor unit (8), wherein the sensors (4, 5, 7) are connected to the processor unit (8), the processor unit (8) comprising:
- at least one memory (9) for storing instructions,
- at least one processor (10) that executes the instructions, the method comprising the following steps:
- measuring RF signals by the sensors (4, 5, 7) inside the operation room (2) and outside the operation room (2) and providing sensor data,
- calculating a noise level based on the sensor data in the processor unit (8),
- carrying out a procedure for suppressing and/or avoiding RF noise based on the noise level.

11. The method according to claim 10 , wherein the step of carrying out a procedure for suppressing and/or avoiding RF noise based on the noise level comprises the step of:
- changing an operation of components of the medical imaging or therapy system (1) based on the noise level.

12. The method according to any one of claims 10 or 11, wherein the step of measuring RF signals by the sensors (4, 5, 7) and providing sensor data comprises the step of:
- sampling signals from the sensor (4) inside the operation room (2) and from the sensor (5) outside the operation room (2) and the step of a processing the sensor data in the processor unit (8) comprises the step of:
- subtracting or dividing the sensor data from inside and outside the operating room (2) for calculating a corresponding noise level.

13. The method according to any one of claims 10 to 12, wherein the at least one processor (10) is arranged to execute a neural network machine learning algorithm and the step of processing of the sensor data in the processor unit (8) comprises the step of:
- feeding the sensor data to the neural network machine learning algorithm, wherein the neural network machine learning algorithm is trained to identify devices by the fingerprint of their spurious signal band.

14. The method according to any one of claims 10 to 13, wherein the step of carrying out a procedure based on the noise level comprises the step of:
- proposing an adapted operation mode for the medical imaging system (1) to an operator to achieve a clinical image with a better image quality.

15. The method according to any one of claims 10 to 14, wherein the medical imaging or therapy system (1) is a magnetic resonance imaging (MRI) system, wherein the sensors (4, 5, 7) inside and outside the operation room (2) are time aligned with an MRI digital multi-receiver of the MRI system and the step of carrying out a procedure based on the noise level comprises the step of:
- removing noise from clinical image in the k-space or in the image space to the extent possible.
